# EUROPEAN PATENT SPECIFICATION

(11) **EP 1 531 481 B1**
(45) Date of publication and mention of the grant of the patent: **22.12.2010**
(21) Application number: 04257001.0
(22) Date of filing: 11.11.2004
(51) Int. Cl.: G11C 11/16, H01F 10/32

(54) **Magnetic tunneling junction cell having free magnetic layer with low magnetic moment and magnetic random access memory having the same**
Magnetische Tunnelübergangsanordnungszelle, enthaltend eine freie magnetische Schicht mit niedrigem magnetischem Moment und magnetischem Direktzugriffsspeicher mit dieser Zelle
Cellule de mémoire avec une jonction à effet tunnel magnétique comprenant une couche magnétique libre ayant un faible moment magnétique et mémoire magnétique utilisant cette dernière

(30) Priority: 14.11.2003 KR 2003080573
(43) Date of publication of application: 18.05.2005
(73) Proprietor: SAMSUNG ELECTRONICS CO., LTD., Suwon-si, Gyeonggi-do (KR)
(72) Inventor: Kim, Tae-wan, Yongin-si, Gyeonggi-do (KR); Park, Sang-jin, Pyeongtaek-si, Gyeonggi-do (KR); Hwang, In-jun, Samsung Adv. Inst. of Technology, Yongin-si, Gyeonggi-do (KR)
(74) Representative: Greene, Simon Kenneth

(56) References cited:
- EP-A- 1 187 103
- EP-A- 1 288 958
- EP-A- 1 437 747
- WO-A-2004/109820
- US-A1- 2003 063 492
- US-A1- 2003 123 197
- US-A1- 2003 184 921
- OLIVER B ET AL: "Dielectric breakdown in magnetic tunnel junctions having an ultrathin barrier" JOURNAL OF APPLIED PHYSICS AIP USA, vol. 91, no. 7, 1 April 2002 (2002-04-01), pages 4348-4352, XP002341443 ISSN: 0021-8979
- SANGJIN PARK ET AL: "Magnetic tunnel junctions with low Ms free layers" PHYSICA STATUS SOLIDI A WILEY-VCH GERMANY, vol. 201, no. 8, June 2004 (2004-06), pages 1640-1643, XP002341474 ISSN: 0031-8965
- KIM T ET AL: "Technological issues for high-density MRAM development" JOURNAL OF MAGNETISM AND MAGNETIC MATERIALS, ELSEVIER SCIENCE PUBLISHERS, AMSTERDAM, NL, vol. 282, November 2004 (2004-11), pages 232-236, XP004600352 ISSN: 0304-8853
- SAKAKIMA; SATOMI H; IRIE M; KAWAWAKE Y: "Magnetoresistance in CoMnB/Co(Fe)/Cu/Co(Fe) spin-valves" JOURNAL OF MAGNETISM AND MAGNETIC MATERIALS, vol. 165, no. 1-3, 1 January 1997 (1997-01-01), - 1 January 1997 (1997-01-01) pages 108-110, XP005882294 Amsterdam NL
- INOMATA K: "PRESENT AND FUTURE OF MAGNETIC RAM TECHNOLOGY" IEICE TRANSACTIONS ON ELECTRONICS, vol. E84C, no. 6, 6 June 2001 (2001-06-06), pages 740-746, XP001060103

## Description

The present invention relates to a semiconductor memory, and more particularly, to a magnetic tunneling junction (MTJ) cell having free magnetic layer with low magnetic moment and a magnetic random access memory (MRAM) having the same.

A magnetic random access memory (MRAM) consists of a transistor and a magnetic tunneling junction (MTJ) cell to which data is stored. The magnetoresistance (MR) ratio of MTJ cell changes depending on magnetic polarization orientation of magnetic layers, which are stacked up and down. The MRAM is a memory device that writes data using these characteristics of the MTJ cell.

In order to accurately read out data from MRAM, it is preferable that the MRAM has a sensing margin as large as possible. The sensing margin is generally determined by the MR ratio of the MTJ cell.

In order to increase the MR ratio of the MTJ cell, stability and uniformity of the MTJ cell must be assured. For this purpose, a tunneling oxide layer of the MTJ cell must have uniform thickness and stability of manufacturing processes must first be established.

In addition, the MRAM must assure selectivity, that is, other MTJ cells adjacent to a selected MTJ cell must not be influenced during an operation of selecting the selected MTJ cell. In case of a well-known MRAM (hereinafter, referred to as a conventional MRAM), however, it has been reported that there occur abnormal phenomena, such as an edge pinning and a vortex pinning, during an operation of writing or reading data to or from an MTJ cell.

Due to these phenomena, larger switching fields are demanded during the data read/write operation. Thus, there exist fail bits, that is, MTJ cells which are not switched by a normal switching field during the data read/write operation. The reason why the fail bits occur is that MTJ cells are not switched in a normal switching field.

FIG. 1 illustrates an edge pinning that occurs in a free magnetic layer during the data read/write operation of the conventional MTJ cell, and FIG. 2 illustrates a variation of hysteresis characteristic by the edge pinning.

FIG. 3 illustrates a vortex pinning that occurs in a free magnetic layer during the data read/write operation of the conventional MTJ cell, and FIG. 4 illustrates a variation of hysteresis characteristic by the vortex pinning.

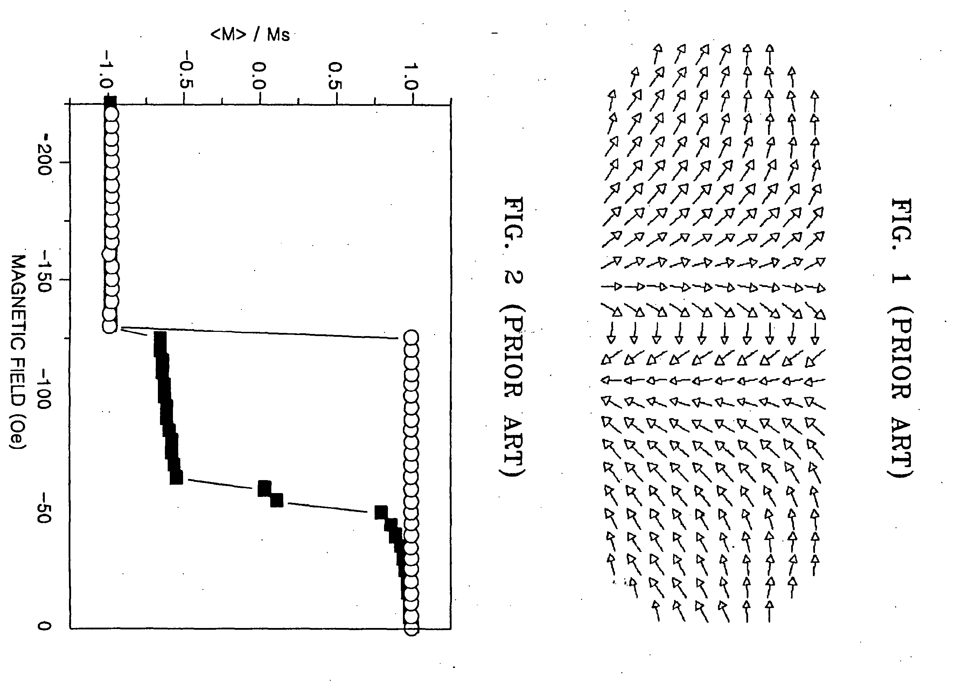

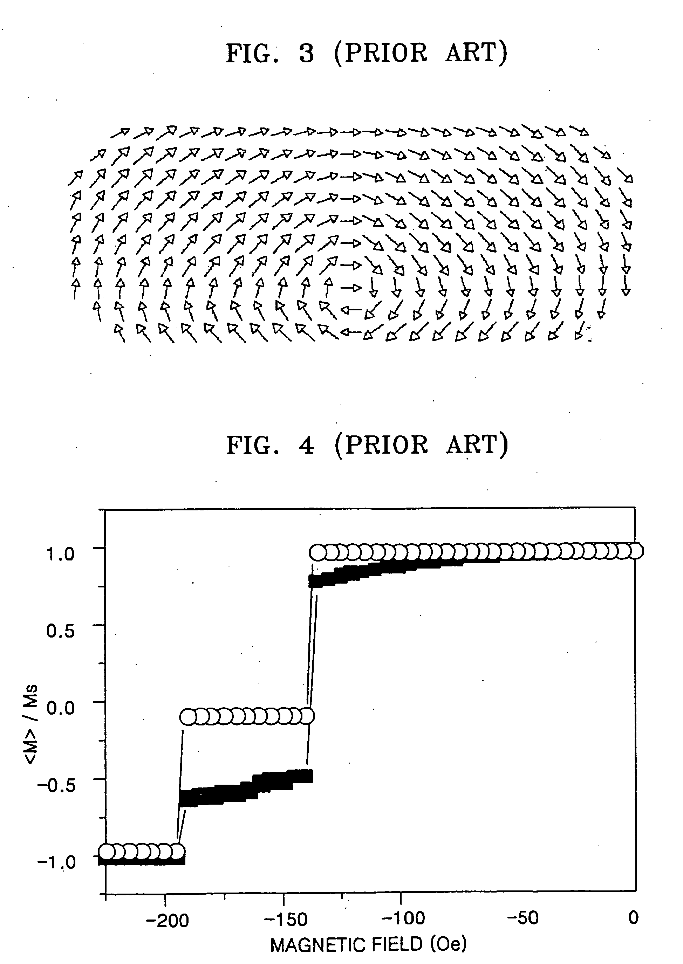

In FIGS. 2 and 4, a reference symbol "■" indicates a hysteresis characteristic when a magnetic field is applied, and a reference symbol "o" indicates a hysteresis characteristic when the applied magnetic field is eliminated.

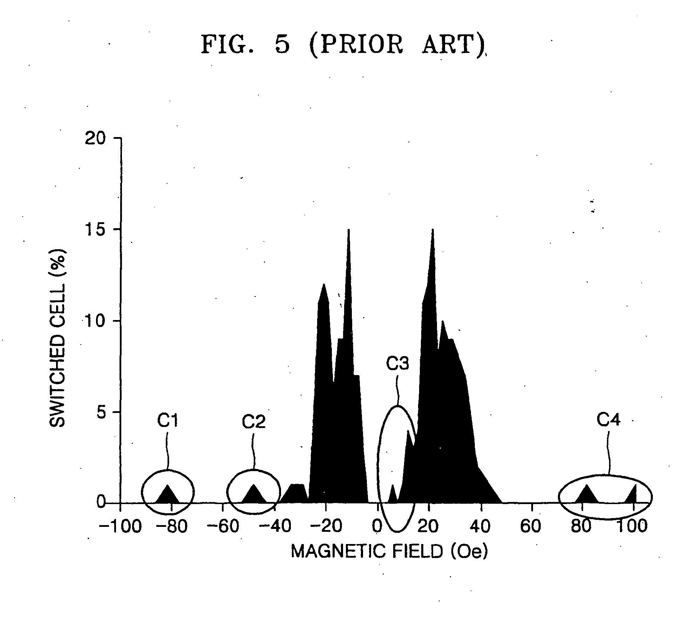

FIG. 5 illustrates a switching distribution of MTJ cells during the data write operation of the conventional MRAM, in which free magnetic layer is formed of CoFe/NiFe, that is, a CoFe layer having a thickness of 10Å and a NiFe layer having a thickness of 30Å. In FIG. 5, reference symbols C1, C2, C3 and C4 indicate ratios of fail bits, that is, MTJ cells that are not switched in a normal switching field.

Referring to FIG. 5, the MTJ cells that are not switched in the normal switching field are switched in a switching field that exceeds far beyond the normal switching field (C1, C2, C4), or switched in a switch field that reaches far below the normal switching field (C3).

In case of the conventional MRAM, the degree of integration can be increased by forming magnetic layer of the MTJ cell, especially free magnetic layer (CoFe/NiFe), to be thinner. As the free magnetic layer is thinner, however, thermal stability in the magnetic moment of the free magnetic layer may be degraded. This means that the MTJ cell is thermally unstable.

US2003/0184921 describes an MTJ cell with a variety of different materials including in one embodiment a CoFe/NiFe bilayer as the free layer.

US2003/0063492 describes a magnetic memory cell. In an embodiment of the invention as a tunnel magnetoresistance (TMR) cell, a soft magnetic layer of CoFe is proposed.A spin-valve magnetoresistance structure is proposed by Sakakima et al, "Magnetoresistance in CoMnB/Co(Fe)/Cu/Co(Fe) spin valves", Journal of Magnetism and magnetic Materials, volume 165, 1997, pages 108 to 110. Various multilayer structures are proposed, including a proposal to substitute CoNbZr for the CoMnB discussed in more detail in the specific examples discussed in Sakakima et al.

According to an aspect of the present invention there is provided an MTJ cell according to claim 1.

The free magnetic layer may be a magnetic layer having a magnetic moment of 800 emu/cm³ or less.

The free magnetic layer may further include a filtering layer that is formed between the magnetic layer and the tunneling layer, in which the filtering layer has a magnetic moment greater than the magnetic layer.

The lower magnetic layer may include a stacked layer of a pinning layer and an SAF (synthetic anti-ferromagnetic) layer.

According to another aspect of the present invention, an MRAM (magnetic random access memory) includes: a transistor; an MTJ cell as claimed.

The free magnetic layer may have characteristics equal to the above description with relation to the MTJ cell. The present invention can prevent abnormal switching phenomena, such as edge pinning and vortex pinning, from occurring in the MTJ cell. Also, the present invention can reduce intensity of a switching field.

The present invention provides an MTJ cell of MRAM that includes thin free magnetic layer in order to increase the degree of integration. The MTJ cell is freed from kinks, which are caused by edge pinning or vortex pinning, and is thermally stable.

Also, the present invention provides an MRAM including the MTJ cell.

The above and other features and advantages of the present invention will become more apparent by describing in detail exemplary embodiments thereof with reference to the attached drawings in which:
FIG. 1 illustrates an edge pinning that occurs in a free magnetic layer of MTJ cell during data write operation of a conventional MRAM;
FIG. 2 illustrates a variation of hysteresis characteristic of MTJ cell by the edge pinning shown in FIG. 1;
FIG. 3 illustrates a vortex pinning that occurs in a free magnetic layer of MTJ cell during data write operation of the conventional MRAM;
FIG. 4 illustrates a variation of hysteresis characteristic of MTJ cell by the vortex pinning shown in FIG. 3;
FIG. 5 illustrates a switching distribution of MTJ cells during data write operation of the conventional MRAM;

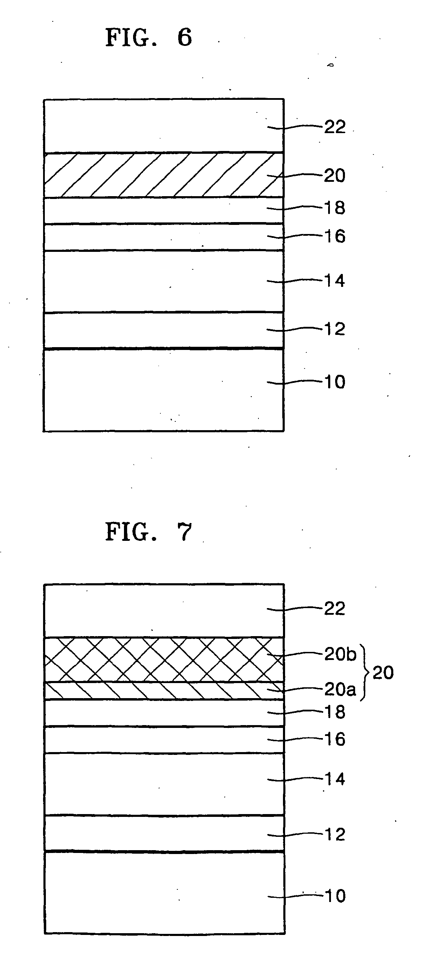

FIG. 6 is a sectional view of an MTJ cell of an MRAM according to an embodiment of the present invention;
FIG. 7 is a sectional view illustrating a case where the free magnetic layer is formed with two magnetic layers in the MTJ cell of FIG. 6;

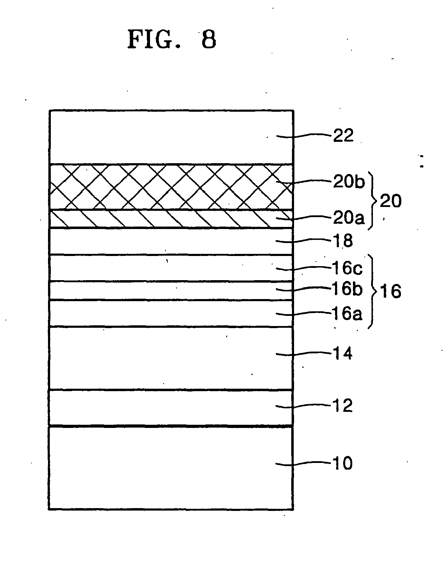

FIG. 8 is a sectional view illustrating a case where the free magnetic layer is formed with two magnetic layers and the pinned layer is formed of an SAF layer in the MTJ cell of FIG. 6;

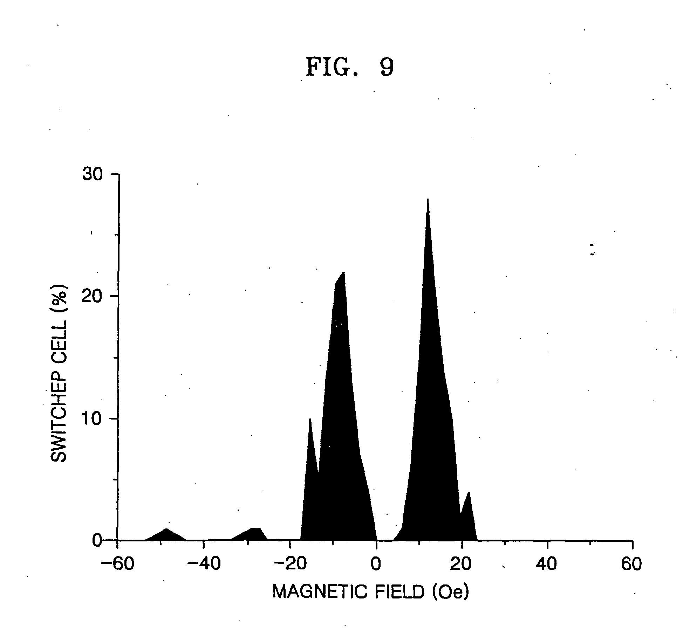

FIG. 9 illustrates a switching distribution of MTJ cells during data write operation of an MRAM;

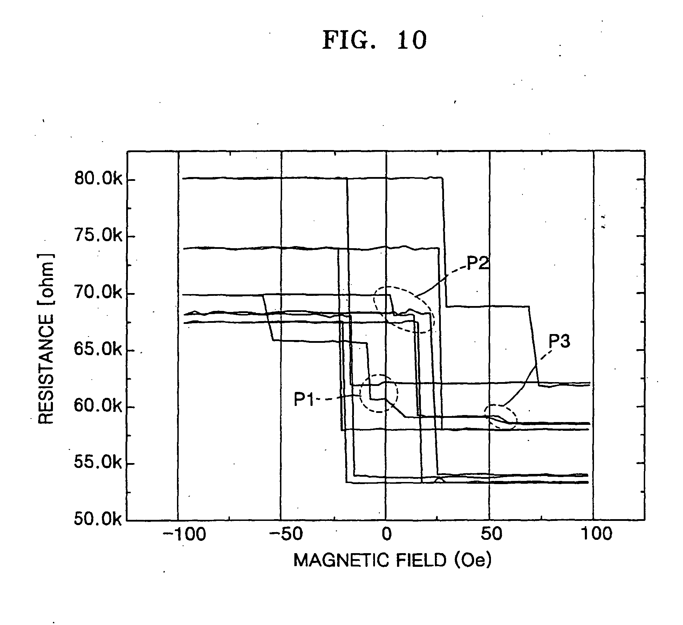

FIG. 10 illustrates H-R characteristics of the conventional MTJ cells;

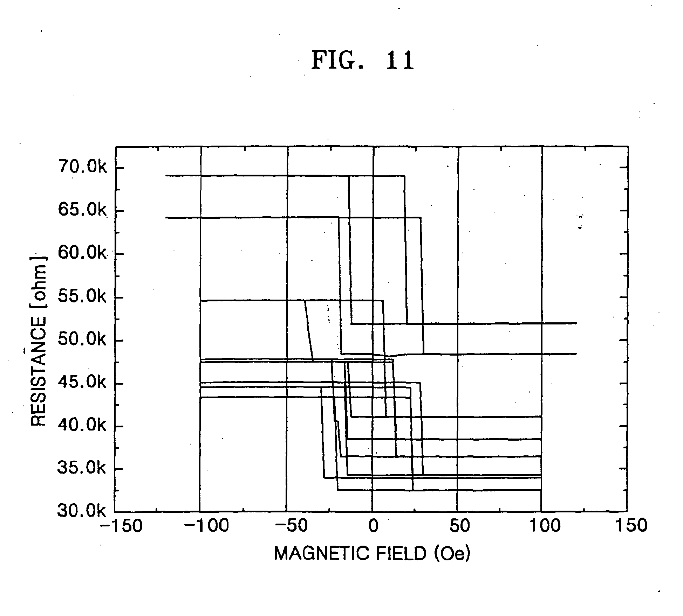

FIG. 11 illustrates H-R characteristics of the MTJ cells of fig. 9, and

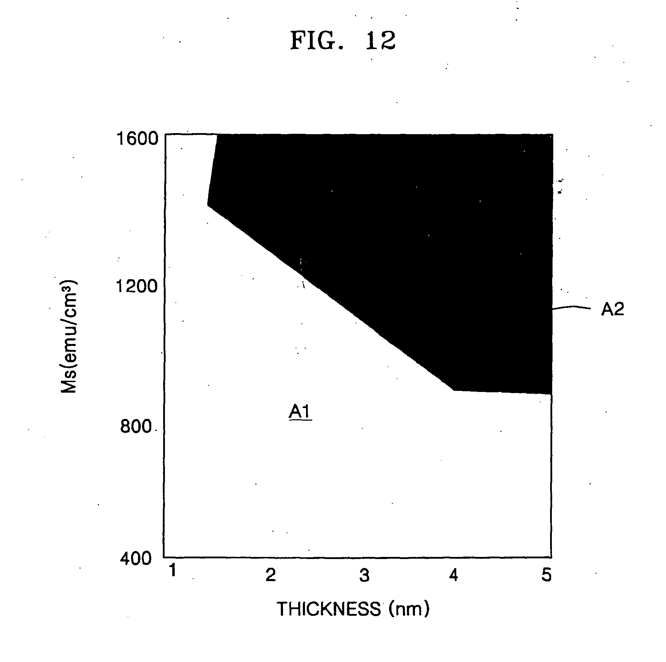

FIGS 12 through 14 illustrates conditions of the MTJ cell and the free magnetic layer, which can make the MTJ cell freed from kinks through correlations of aspect ratio of the MTJ cell, magnetic moment and thickness of the free magnetic layer.

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, the thickness of layers and regions are exaggerated for clarity. Like reference numerals in the drawings denote like elements, and thus their description will be omitted.

FIG. 6 is a sectional view of MTJ cell of MRAM according to an embodiment of the present invention.

Referring to FIG. 6, the MTJ cell according to the present invention includes a pad conductive layer 10 (hereinafter, referred to as a lower electrode) that is connected to a switching element, for example, a transistor. The lower electrode 10 may be a tantalum (Ta) electrode or a titanium nitride (TiN) electrode. Also, the MTJ cell according to the present invention includes a seed layer 12, a pinning layer 14, a pinned layer 16, a tunnelling layer 18, a free magnetic layer 20, and a capping layer 22, which are sequentially stacked on the lower electrode 10. An upper electrode (not shown) is stacked on the capping layer 22. The seed layer 12 may be an amorphous metal layer, a ruthenium (Ru) layer, or a nickel iron (NiFe) layer. The pinning layer 14 may be an anti-ferromagnetic layer, for example, an iridium magnesium (IrMn) layer or a platinum magnesium (PtMn). The pinned layer 16 may be a single layer or include a plurality of material layers. In case where the pinned layer 16 includes a plurality of material layers, the pinned layer 16 may be a synthetic anti-ferromagnetic (SAF) layer shown in FIG. 8, which is formed by stacking a first pinned layer 16a, an intermediate layer 16b and a second pinned layer 16c in sequence. The first pinned layer 16a may be an anti-ferromagnetic layer, for example, a cobalt iron (CoFe) layer. The intermediate layer may be a metal layer, for example, a ruthenium (Ru) layer. The second pinned layer 16c may be an anti-ferromagnetic layer, for example, a cobalt iron (CoFe) layer. The seed layer 12, the pinning layer 14 and the pinned layer may constitute a lower magnetic layer.

The tunnelling layer 18 may be an oxide layer having a predetermined thickness, for example, an aluminium oxide (AlOₓ) layer of 15Å in thickness. The free magnetic layer 20 may be a material layer having a predetermined magnetic moment in a predetermined thickness, and is, an amorphous material layer having a thickness of 5 nm or less and a magnetic moment of 800 emu/cm³ or less. The amorphous material layer having the magnetic moment of 800 emu/cm³ or less can be divided into a first amorphous compound layer and a second amorphous compound layer. It is preferable that the first amorphous compound layer is an amorphous rare-earth transition metal compound layer having a magnetic moment of less than 400 emu/cm³, but the first amorphous compound layer may also be other material layer. It is preferable that the second amorphous compound layer is an amorphous transition metal compound layer having a magnetic moment of less than 600 emu/cm³, but the second amorphous compound layer may also be other material layer. For example, the amorphous rare-earth transition metal compound layer may be a cobalt terbium (CoTb) layer and the amorphous transition metal compound layer is a cobalt zirconium compound (CoZrX). Here, "X" may be terbium (Tb) or niobium (Nb).

Although the free magnetic layer 20 may be a single layer, it is preferable that the free magnetic layer 20 is a double layer if considering an increase of MR ratio, as shown in FIGS. 7 and 8.

Referring to FIG. 7, the free magnetic layer 20 includes first and second magnetic layers 20a and 20b, which are stacked sequentially. The first magnetic layer 20a is a filtering layer that increases MR ratio of the free magnetic layer 20. The first magnetic layer 20a may be a ferromagnetic layer having large polarizability, for example, a cobalt iron (CoFe) layer. The second magnetic layer 20b may be an amorphous material layer having a magnetic moment of 800 emu/cm³ or less. Even when the free magnetic layer 20 is formed with the first and second magnetic layers 20a and 20b, it is preferable that a total thickness of the free magnetic layer 20 is 5 nm or less.

The capping layer 22 that is stacked on the free magnetic layer 20 is a layer that protects the free magnetic layer 20 during an etching process. The capping layer 22 may be a ruthenium (Ru) layer.

A characteristic of the MTJ cell will now be described.

FIG. 9 illustrates an occurrence of fail bits in an array of the MTJ cells, in which the MTJ cells include the free magnetic layer formed with 5Å-thick CoFe layer and 30Å-thick NiFe layer.

Comparing FIGS. 5 and 9, it can be seen that the occurrence of fail bits is much less in the array consisting of the MTJ cells of Figure 9. This means that most of the MTJ cells of Figure 9 are switched normally.

FIGS. 10 and 11 illustrate H-R characteristic curves of the MTJ cells according to the prior art and Figure 9, respectively. In FIG. 10, reference symbols P1 and P2 indicate distorted portions of the H-R characteristic curve, which are caused by a vortex pinning, and a reference symbol P3 is a distorted portion of the H-R characteristic curve, which is caused by an edge pinning.

Comparing FIGS. 10 and 11, it can be seen that the distorted portions P1, P2 and P3 of FIG. 10 do not appear in FIG. 11. These results show that the MTJ cells according Figure 9 are freed from kink that is caused by the edge pinning or the vortex pinning.

FIGS. 12 through 14 illustrate a correlation of aspect ratio (AR) of the MTJ cell, thickness of the free magnetic layer and kink of the MTJ cell. In FIGS. 12 through 14, a reference symbol A1 indicates an area having no kink and a reference symbol A2 indicates an area having the kink.

Referring to FIG. 12, in case where the aspect ratio of the MTJ cell is "1", the MTJ cell is freed from the kink if the free magnetic layer has a thickness of 5 nm and a magnetic moment (Ms) of 800 emu/cm³. Further, as the free magnetic layer is thinner, for example, 3 nm or less in thickness, the MTJ cell can be freed from the kink even when the free magnetic layer of the magnetic moment (Ms) has a magnetic moment (Ms) of 1000 emu/cm³ or more.

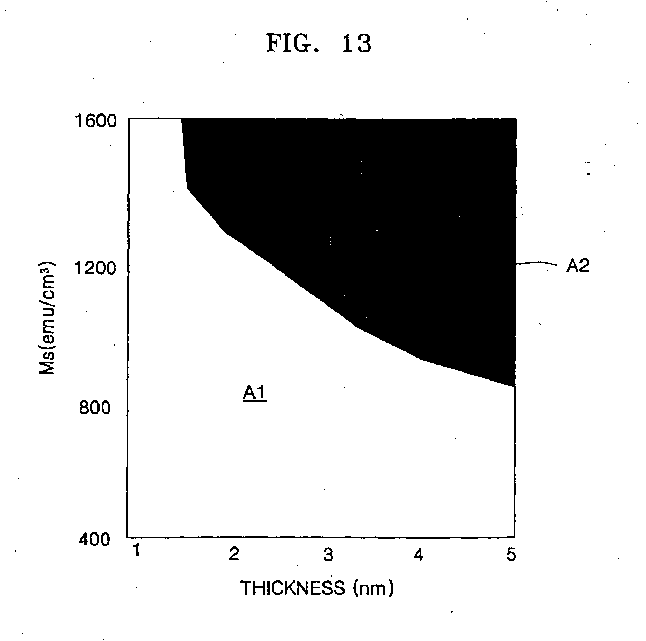

Referring to FIG. 13, in case where an aspect ratio of the MTJ cell is "1.5", the above tendency can also be applied equally.

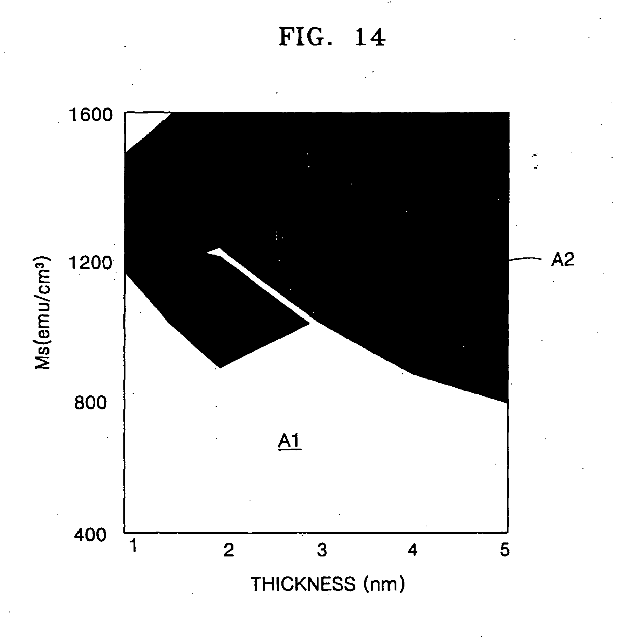

FIG. 14 illustrates a condition that makes the MTJ cell freed from the kink in case where an aspect ratio of the MTJ cell is "2".

Referring to FIG. 14, it can be seen that the MTJ cell is not freed from the kink in case where the free magnetic layer has a thickness of more than 5 nm.

From the results of FIGS. 12 through 14, in order for the MTJ cells of FIGS. 6 through 8 to be freed from the kink, it is preferable that the free magnetic layer 20 is formed of a material layer having the above-described thickness and magnetic moment. Also, it is preferable that the aspect ratio of the MTJ cell is 2 or less.

Meanwhile, the MRAM according to the present invention may include a typical transistor (for example, a field effect transistor (FET)) formed on a substrate, the MTJ cell of FIG. 6, 7 or 8 connected to the transistor, and an interlayer insulating layer surrounded by them. Also, the MRAM according to the present invention may include data line that is used to write data to the MTJ cell.

Since the MTJ cell is described above and the other elements are well known, a configuration of the MRAM according to the present invention will be omitted.

As described above, the MTJ cell of the MRAM according to the present invention has the aspect ratio of 2 or less. Also, the MTJ cell includes the free magnetic layer that is formed of the amorphous compound layer having the thickness of 5 nm or less and the magnetic moment of 800 emu/cm³ or less. Accordingly, in case of using the MTJ cell of the MRAM according to the present invention, the degree of integration can be increased by forming the thinner free magnetic layer. In addition, the thermal stability can be assured and the MTJ cell can be freed from the kink. Further, since the free magnetic layer has the small magnetic moment, strength of the switching field can be reduced.

The free magnetic layer can be formed with triple layers.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An magnetic tunneling junction cell, in short an MTJ cell, comprising:
a lower electrode (10); and
a lower magnetic layer (12,14,16), a tunneling layer (18), an upper magnetic layer (20) and an upper electrode, which are sequentially stacked on the lower electrode,
wherein the upper magnetic layer (20) includes a free magnetic layer of 5 nm or less in thickness,
wherein the MTJ cell has an aspect ratio of 2 or less
wherein the free magnetic layer comprises an amorphous transition metal compound layer being one of CoZrTb and CoZrNb.

2. The MTJ cell of claim 1, wherein the free magnetic layer is a magnetic layer having a magnetic moment of 800 emu/cm³ or less

3. The MTJ cell of claim 2, wherein the free magnetic layer (20) further includes a filtering layer (20a) that is formed between the magnetic layer and the tunneling layer, the filtering layer having a magnetic moment greater than the magnetic layer.

4. The MTJ cell of claim 3, wherein the filtering layer (20a) is a CoFe layer.

5. The MTJ cell of any preceding claim, wherein the lower magnetic layer (12,14,16) includes a stacked layer of a pinning layer (12) and a SAF, synthetic anti-ferromagnetic, layer (16).

6. An MRAM (magnetic random access memory), comprising:
a transistor;
and an MTJ cell according to any preceding claim.

7. The MRAM of claim 6, wherein the free magnetic layer (20) further includes a filtering layer (20a) having a magnetic moment greater than the magnetic layer.

8. The MRAM of claim 7, wherein the filtering layer (20a) is a CoFe layer.

## Patentansprüche

1. Magnetische Tunnelübergangszelle, kurz eine MTJ-Zelle, umfassend:
eine untere Elektrode (10) und
eine untere Magnetschicht (12, 14, 16), eine Tunnelschicht (18), eine obere Magnetschicht (20) und eine obere Elektrode, die sequentiell auf der unteren Elektrode aufgeschichtet sind,
wobei die obere Magnetschicht (20) eine freie Magnetschicht mit einer Dicke von 5 nm oder weniger aufweist,
wobei die MTJ-Zelle ein Aspektverhältnis von 2 oder weniger aufweist,
wobei die freie Magnetschicht eine amorphe Übergangsmetallverbindungsschicht umfasst, die aus CoZrTb oder CoZrNb gebildet ist.

2. MTJ-Zelle nach Anspruch 1, wobei die freie Magnetschicht eine Magnetschicht mit einem magnetischen Moment von 800 emu/cm³ oder weniger ist.

3. MTJ-Zelle nach Anspruch 2, wobei die freie Magnetschicht (20) weiter eine Filterschicht (20a) umfasst, die zwischen der Magnetschicht und der Tunnelschicht ausgebildet ist, wobei die Filterschicht ein höheres magnetisches Moment aufweist als die Magnetschicht.

4. MTJ-Zelle nach Anspruch 3, wobei die Filterschicht (20a) eine i CoFe-Schicht ist.

5. MTJ-Zelle nach einem der vorhergehenden Ansprüche, wobei die untere Magnetschicht (12, 14, 16) eine Stapelschicht aus einer Pinning-Schicht (12) und einer synthetischen antiferromagnetischen (SAF) Schicht (16) aufweist

6. Magnetischer Direktzugriffspeicher (MRAM), umfassend:
einen Transistor und
eine MTJ-Zelle nach einem der vorhergehenden Ansprüche

7. MRAM nach Anspruch 6, wobei die freie Magnetschicht (20) weiter eine Filterschicht (20a) umfasst, die ein höheres magnetisches Moment aufweist als die Magnetschicht.

8. MRAM nach Anspruch 7, wobei die Filterschicht (20a) eine CoFe-Schicht ist.

## Revendications

1. Cellule de jonction à effet tunnel magnétique (MTJ), en bref cellule MTJ, comprenant:
une électrode inférieure (10) ; et
une couche magnétique inférieure (12, 14, 16), une couche à effet tunnel (18), une couche magnétique supérieure (20) et une électrode supérieure, qui sont empilées séquentiellement sur l'électrode inférieure,
où la couche magnétique supérieure (20) inclut une couche magnétique libre de 5 nm ou moins d'épaisseur,
où la cellule MTJ a un rapport de côté de 2 ou moins ;
où la couche magnétique libre comprend une couche de composé de métal de transition amorphe qui est un élément parmi CoZrTb et CoZrNb.

2. Cellule MTJ selon la revendication 1, dans laquelle la couche magnétique libre est une couche magnétique ayant un moment magnétique de 800 emu/cm³ ou moins.

3. Cellule MTJ selon la revendication 2, dans laquelle la couche magnétique libre (20) inclut en outre une couche de filtration (20a) qui est formée entre la couche magnétique et la couche à effet tunnel, la couche de filtration ayant un moment magnétique supérieur à la couche magnétique.

4. Cellule MTJ selon la revendication 3, dans laquelle la couche de filtration (20a) est une couche en CoFe.

5. Cellule MTJ selon l'une quelconque des revendications précédentes, dans laquelle la couche magnétique inférieure (12, 14, 16) inclut une couche empilée d'une couche de brochage (12) et une couche antiferromagnétique synthétique (16) (SAF).

6. MRAM (mémoire vive magnétique), comprenant :
un transistor ;
et une cellule MTJ selon l'une quelconque des revendications précédentes.

7. MRAM selon la revendication 6, dans laquelle la couche magnétique libre (20) inclut en outre une couche de filtration (20a) ayant un moment magnétique supérieur à la couche magnétique.

8. MRAM selon la revendication 7, dans lequel la couche de filtration (20a) est une couche en CoFe.
